# EUROPEAN PATENT SPECIFICATION

(11) **EP 1 524 705 B1**
(45) Date of publication and mention of the grant of the patent: **12.03.2008**
(21) Application number: 05000492.8
(22) Date of filing: 12.01.2005
(51) Int. Cl.: H01L 33/00, H01L 25/075

(54) **Flip chip type LED lighting device and its manufacturing method**
Beleuchtungsvorrichtung mit Leuchtdioden vom Flip-Chip -Typ und Verfahren zu ihrer Herstellung
Dispositif d'illumination avec des diodes électroluminescentes de type flip-chip et procédé de sa manufacture

(43) Date of publication of application: 20.04.2005
(73) Proprietor: NeoBulb Technologies, Inc., Bandar Seri Begawan (BN)
(72) Inventor: Chen, Jeffrey, Hsinchu City 300 (TW); Lin, Chung-Zen, Kaohsiung City (TW)
(74) Representative: Casalonga, Axel

(56) References cited:
- EP-A- 1 467 417
- US-A1- 2001 003 372
- US-A1- 2002 105 002
- US-A1- 2004 047 151
- US-A1- 2004 079 957
- US-B1- 6 310 364
- US-B1- 6 809 261

## Description

### BACKGROUND OF THE INVENTION

### 1. Field of the Invention:

The present invention relates to a lighting device manufacturing method and more particularly, to a simple method of making flip chip type LED lighting devices without wire bonding.

### 2. Description of the Related Art:

A lighting device is a requisite in our daily life. It lights up the space when dark. Following fast development of high technology, flip chip LEDs have been intensively used to substitute for conventional incandescent lamps.

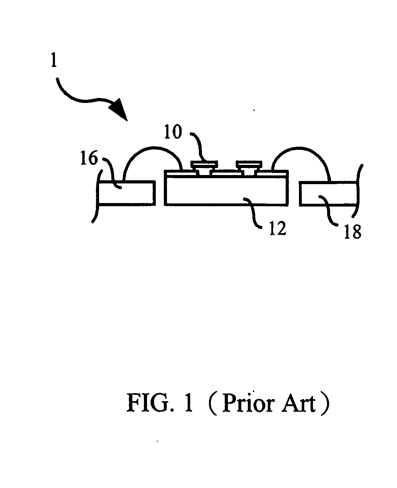

FIG. 1 is a schematic sectional view of a flip chip type LED lighting device made according to the prior art. According to this design, the flip chip type LED lighting device **1** comprises a submount **12,** bond fingers **16, 18** provided at two sides of the submount **12,** and a plurality of flip chip LEDs (light emitting diodes) **10** bonded on the submount **12** and electrically connected to the bond fingers **16, 18** by wire bonding. According to this design, a die bonding and a wire bonding procedures must be employed to have the legs of the LEDs **10** connected to the bond fingers **16, 18.** This wire bonding procedure is complicated. During wire bonding, the LEDs **10** or submount **12** may be damaged accidentally.

Therefore, it is desirable to provide a flip chip type LED lighting device manufacturing method, which eliminates the aforesaid problem.

### SUMMARY OF THE INVENTION

The present invention has been accomplished under the circumstances in view. It is one object of the present invention to provide a flip chip type LED lighting device manufacturing method, which eliminates the application of wire bonding. It is another object of the present invention to provide a flip chip type LED lighting device manufacturing method, which has the bottom wall of the submount exposed to the outside for the bonding of a heat conducting/dissipating member to improve the heat dissipation effect of the lighting device. To achieve these and other objects of the present invention, the flip chip type LED lighting device manufacturing method comprises the steps of a) providing a strip, the strip comprising a plurality of strip elements, the strip elements having a respective metal lead frame respectively electrically connected to one another; b) providing a submount and a plurality of flip chip LEDs (light emitting diodes) installed in the submount; c) forming a metal bonding layer between the strip bond pad, that has been pre-fixed in the strip, and the submount to form a lighting structure; and d) cutting the lighting structure thus obtained into individual flip chip type LED lighting devices based on each strip element. The method of the invention further comprises the step of bonding a heat conducting/dissipating member to the submount of each individual flip chip type LED lighting device.

### BRIEF DESCRIPTION OF THE DRAWINGS

FIG. 1 is a schematic sectional view of a flip chip type LED lighting device made according to the prior art.
FIG. 2 is a block diagram showing the flow of a flip chip type LED lighting device manufacturing method according to the present invention.
FIG. 3 is a schematic drawing of a strip for the fabrication of a flip chip type LED lighting device according to the present invention.
FIG. 4 is a schematic sectional view of a flip chip type LED lighting device made according to the present invention.
FIG. 5 is a schematic sectional view of a light module based on a flip chip type LED lighting device according to the present invention.

### DETAILED DESCRIPTION OF THE PREFERRED EMBODIMENT

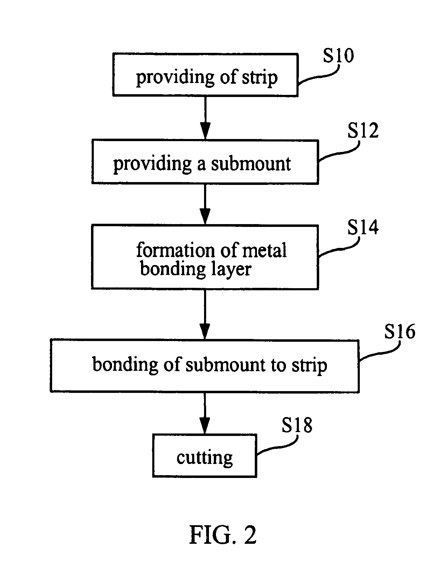

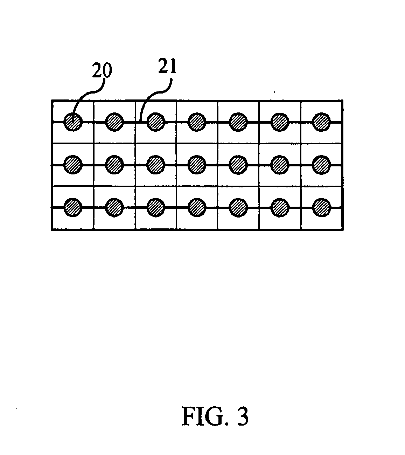

Referring to FIG. 2, a flip chip type LED lighting device manufacturing method in accordance with the present invention includes the steps of:
S10-providing a strip, as FIG. 3 shown, wherein the strip is prepared having a plurality of strip elements **20**, each strip element **20** having a metal lead frame **21**, the metal lead frames **21** of the strip elements **20** being respectively electrically connected together;
S12-providing a submount, for example, silicon or low temperature co-firing ceramic(LTCC) submount is provided, and a plurality of light emitting elements, for example, light emitting diodes are installed on the silicon submount by flip chip;
S14-formation of metal bonding layer where a metal bonding layer is formed on the bottom wall of the strip or the top wall of the submount with a low temperature solder material for example, tin base alloy, bismuth base alloy, or indium base alloy, or by means of eutectic bonding, or gold to gold ultrasonic bonding to form a lighting structure;
S16-bonding of sub-mount to strip where the submount is attached to the bottom side of the strip and at the same time the submount is heated to melt the metal bonding layer to fix the submount to the strip and to electrically connect the metal lead frames to the bond pads of the submount, or using a lower bonding temperature by associating with ultrasonic energy; and
S18-cutting where the structure thus obtained is cut into individual flip chip type LED lighting devices each containing one strip element.

After the aforesaid step S 18, a heat conducting/dissipating member is provided under and fixedly fastened to each individual flip chip type LED lighting device. The heat conducting/dissipating member could be bonded to the flip chip type LED lighting device by means of the application of a conductive adhesive containing silver or copper filler. Alternatively, a low temperature solder material may be directly applied on the bottom wall of the flip chip type LED lighting device and following treated with thermal process (Ex. reflow) to achieve the bonding. It is also constructive to bond a heat conducting/dissipating member to the bottom wall of each individual flip chip type LED lighting device by means of eutectic bonding.

After bonding of a heat conducting/dissipating member to the bottom wall of each individual flip chip type LED lighting device, a light condensing element, for example, condenser lens or reflector is used to adjust the light path of the lighting device, enhancing the radiation brightness.

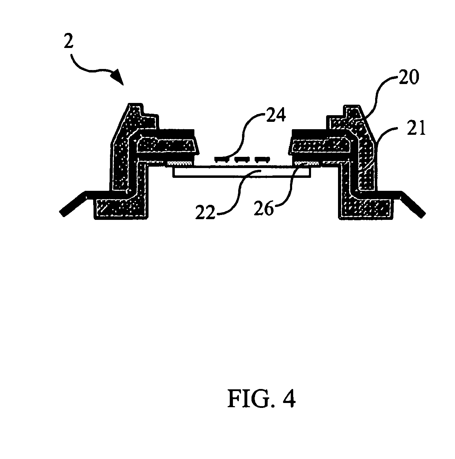

FIG. 4 is a sectional view of a flip chip type LED lighting device **2** made according to the present invention. As illustrated, the flip chip type LED lighting device **2** comprises a strip element **20,** a metal lead frame **21** embedded in the strip element **20,** a flip chip embedded submount **22** bonded to the strip element **20,** flip chip LEDs **24** bonded to circuits on the strip element **20,** and a metal, for example, conductive or Ag paste bonding layer **26** between the strip element **20** and the sub-mount **22**.

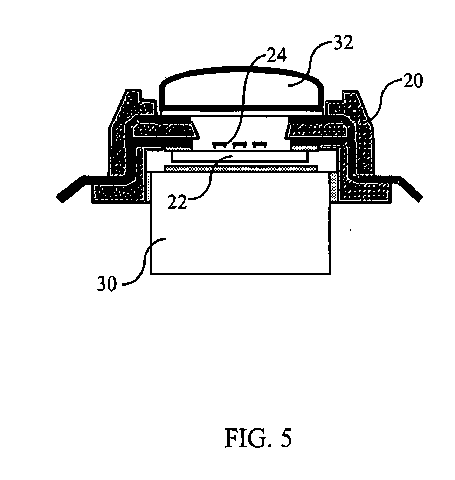

FIG. 5 is a light module based on the aforesaid flip chip type LED lighting device. As illustrated, the light module comprises a flip chip type LED lighting device **2**, a heat conducting/dissipating member **30** bonded to the bottom wall of the submount **22** by means of a thermal interface material (TIM), for example, silver glue, copper glue, low temperature solder material, and a light condensing element **32** covering the top side of the flip chip type LED lighting device **2** to concentrate the light of the flip chip LEDs **24**.

As indicated above, The method of the present invention comprises the step of providing a strip, the step of providing a submount, the step of forming a metal bonding layer on the strip or submount, the step of bonding the submount to the strip, and the step of cutting the structure thus obtained into individual flip chip type LED lighting devices. This method eliminates the procedure of wire bonding as is commonly seen in the prior art designs. Therefore, the invention simplifies the fabrication of flip chip type LED lighting devices.

Although a particular embodiment of the invention has been described in detail for purposes of illustration, various modifications and enhancements may be made without departing from the scope of the appended claims.

## Claims

1. A flip chip type LED lighting device manufacturing method comprising the steps of:
providing a strip, said strip comprising a plurality of strip elements, said strip elements having a respective metal lead frame respectively electrically connected to one another;
providing a submount and a plurality of flip chip LEDs (light emitting diodes) installed in said submount;
forming a metal bonding layer between said strip and said submount to bond said submount to said strip to form a lighting structure; and
cutting the lighting structure thus obtained into individual flip chip type LED lighting devices based on each said strip element.

2. The flip chip type LED lighting device manufacturing method as claimed in claim 1, wherein said submount is a silicon submount having circuits arranged thereon for the bonding of said flip chip LEDs.

3. The flip chip type LED lighting device manufacturing method as claimed in claim 1, wherein said metal bonding layer is formed of a low temperature solder material.

4. The flip chip type LED lighting device manufacturing method as claimed in claim 3, wherein said low temperature solder material is selected from a group of alloys including tin base alloy, bismuth base alloy, and indium base alloy.

5. The flip chip type LED lighting device manufacturing method as claimed in claim 3, wherein said submount is bonded to said strip by said metal bonding layer by means of heating said metal bonding layer to a molten status.

6. The flip chip type LED lighting device manufacturing method as claimed in claim 1, wherein said metal bonding layer is formed of a electric conductive adhesive paste.

7. The flip chip type LED lighting device manufacturing method as claimed in claim 6, wherein said submount is bonded to said strip by said metal bonding layer by means of heating said electric conductive adhesive paste to a hardening status.

8. The flip chip type LED lighting device manufacturing method as claimed in claim 1, wherein said metal bonding layer is bonded to the metal lead frames of said strip elements and said submount by means of eutectic bonding.

9. The flip chip type LED lighting device manufacturing method as claimed in claim 1, further comprises the step of bonding a heat conducting/dissipating member to the submount of each said individual flip chip type LED lighting device.

10. The flip chip type LED lighting device manufacturing method as claimed in claim 9, wherein said heat conducting/dissipating member is bonded to said submount by means of a thermal interface material (TIM).

11. The flip chip type LED lighting device manufacturing method as claimed in claim 10, wherein said thermal interface material (TIM) is selected from a material group including silver glue, copper glue, and a low temperature solder material.

12. The flip chip type LED lighting device manufacturing method as claimed in claim 9, further comprising the step of bonding a light condensing means to the strip element of each said individual flip chip type LED lighting device after the bonding of heat conducting/dissipating member.

13. The flip chip type LED lighting device manufacturing method as claimed in claim 12, said light condensing means comprises a condenser lens and a reflector.

14. The flip chip type LED lighting device manufacturing method as claimed in claim 1, wherein each said individual flip chip type LED lighting device comprises one said metal lead frame, a part of said metal bonding layer, and a part of said submount having at least one said flip chip LED.

15. A flip chip type LED lighting device, comprising:
a strip element (20) having a metal lead frame (21);
a submount (22) having at least one flip chip LED thereon; and
a metal bonding layer (26) between the strip element and the submount to connect the strip element and the submount electrically.

16. The flip chip type LED lighting device as claimed in claim 15, wherein said submount (22) comprises circuits for bonding said flip chip LED on the submount.

17. The flip chip type LED lighting device as claimed in claim 15, wherein said metal bonding layer (26) is positioned below a part of the strip element (20) and above a part of the submount (22).

18. The flip chip type LED lighting device as claimed in claim 15, wherein material of the submount (22) is silicon.

19. The flip chip type LED lighting device as claimed in claim 15, wherein material of the strip element (20) is low temperature co-fired ceramic (LTCC).

20. The flip chip type LED lighting device as claimed in claim 15, further comprising a heat conducting/dissipating member (30) on a bottom of the submount (22).

21. The flip chip type LED lighting device as claimed in claim 20, wherein said heat conducting/dissipating member (30) is bonded to said submount (22) by means of a thermal interface material (TIM).

22. The flip chip type LED lighting device as claimed in claim 21, wherein said thermal interface material (TIM) is selected from a material group including silver glue, copper glue, a low temperature solder material, and a eutectic- bonding metal layer.

23. The flip chip type LED lighting device as claimed in claim 15, further comprising a light condensing element (32) covering the strip element.

24. The flip chip type LED lighting device as claimed in claim 23, said light condensing element is a condenser lens or a reflector.

## Patentansprüche

1. Herstellungsverfahren für ein LED-Beleuchtungs-Bauelement vom Flip-Chip-Typ, das folgende Schritte umfasst:
Bereitstellen eines Streifens, wobei der Streifen eine Vielzahl von Streifenelementen enthält, wobei die Streifenelemente einen entsprechenden Metall-Leiterrahmen haben und jeweils miteinander elektrisch verbunden sind;
Bereitstellen eines unteren Halters und einer Vielzahl von Flip-Chip-LEDs (Leuchtdioden), die auf dem unteren Halter installiert sind;
Ausbilden einer Metall-Verbindungs-Schicht zwischen dem Streifen und dem unteren Halter, um den unteren Halter mit dem Streifen zu verbinden, um eine Beleuchtungs-Struktur herzustellen; und
Schneiden der so erhaltenen Beleuchtungs-Struktur in einzelne LED-Beleuchtungs-Bauelemente vom Flip-Chip-Typ, die auf jedem Streifen-Element basieren.

2. Herstellungsverfahren für ein LED-Beleuchtungs-Bauelement vom Flip-Chip-Typ, wie in Anspruch 1 beansprucht, wobei der untere Halter ein unterer Halter aus Silizium ist, auf dem Schaltkreise für das Bonden der Flip-Chip-LEDs angeordnet sind.

3. Herstellungsverfahren für ein LED-Beleuchtungs-Bauelement vom Flip-Chip-Typ, wie in Anspruch 1 beansprucht, wobei die Metall-Verbindungs-Schicht aus einem Niedrigtemperatur-Lötmaterial hergestellt wird.

4. Herstellungsverfahren für ein LED-Beleuchtungs-Bauelement vom Flip-Chip-Typ, wie in Anspruch 3 beansprucht, wobei das Niedrigtemperatur-Lötmaterial aus einer Gruppe von Legierungen ausgewählt wird, die eine Legierung auf Zinn-Basis, eine Legierung auf Wismut-Basis und eine Legierung auf Indium-Basis enthält.

5. Herstellungsverfahren für ein LED-Beleuchtungs-Bauelement vom Flip-Chip-Typ, wie in Anspruch 3 beansprucht, wobei der untere Halter durch die Metall-Verbindungs-Schicht mit dem Streifen verbunden wird, indem die Metall-Verbindungs-Schicht erhitzt wird, bis sie den geschmolzenen Zustand erreicht.

6. Herstellungsverfahren für ein LED-Beleuchtungs-Bauelement vom Flip-Chip-Typ, wie in Anspruch 1 beansprucht, wobei die Metall-Verbindungs-Schicht aus einer elektrisch leitfähigen Klebstoff-Paste hergestellt wird.

7. Herstellungsverfahren für ein LED-Beleuchtungs-Bauelement vom Flip-Chip-Typ, wie in Anspruch 6 beansprucht, wobei der untere Halter durch die Metall-Verbindungs-Schicht mit dem Streifen verbunden wird, indem die elektrisch leitfähige Klebstoff-Paste erhitzt wird, bis sie einen gehärteten Zustand erreicht.

8. Herstellungsverfahren für ein LED-Beleuchtungs-Bauelement vom Flip-Chip-Typ, wie in Anspruch 1 beansprucht, wobei die Metall-Verbindungs-Schicht mit den Metall-Leiterrahmen der Streifen-Elemente und dem unteren Halter durch eutektisches Bonden verbunden wird.

9. Herstellungsverfahren für ein LED-Beleuchtungs-Bauelement vom Flip-Chip-Typ, wie in Anspruch 1 beansprucht, das weiterhin den Schritt des Bondens eines Wärmeleitungs-Elementes / Kühlkörpers mit dem unteren Halter jedes einzelnen LED-Beleuchtungs-Bauelementes vom Flip-Chip-Typ umfasst.

10. Herstellungsverfahren für ein LED-Beleuchtungs-Bauelement vom Flip-Chip-Typ, wie in Anspruch 9 beansprucht, wobei das Wärmeleitungs-Element / der Kühlkörper mit dem unteren Halter durch ein Wärmeleitmaterial (Thermal Interface Material, TIM) verbunden ist.

11. Herstellungsverfahren für ein LED-Beleuchtungs-Bauelement vom Flip-Chip-Typ, wie in Anspruch 10 beansprucht, wobei das Wärmeleitmaterial (TIM) aus einer Materialgruppe ausgewählt wird, die Silber-Kleber, Kupfer-Kleber und ein Niedrigtemperatur-Lötmaterial umfasst.

12. Herstellungsverfahren für ein LED-Beleuchtungs-Bauelement vom Flip-Chip-Typ, wie in Anspruch 9 beansprucht, das weiterhin den Schritt des Befestigens einer Licht-Sammlungs-Einrichtung am Streifen-Element jedes einzelnen LED-Beleuchtungs-Bauelementes vom Flip-Chip-Typ nach dem Befestigen des Wärmeleitungs-Elementes / Kühlkörpers umfasst.

13. Herstellungsverfahren für ein LED-Beleuchtungs-Bauelement vom Flip-Chip-Typ, wie in Anspruch 12 beansprucht, wobei die Licht-Sammlungs-Einrichtung ein Kondensor und einen Reflektor umfasst.

14. Herstellungsverfahren für ein LED-Beleuchtungs-Bauelement vom Flip-Chip-Typ, wie in Anspruch 1 beansprucht, wobei jedes einzelne LED-Beleuchtungs-Bauelement vom Flip-Chip-Typ einen Metall-Leiterrahmen, einen Teil der Metall-Verbindungs-Schicht und einen Teil des unteren Halters umfasst und mindestens eine Flip-Chip-LED enthält.

15. LED-Beleuchtungs-Bauelement vom Flip-Chip-Typ, umfassend:
ein Streifenelement (20), das einen Metall-Leiterrahmen (21) hat;
einen unteren Halter (22), auf dem sich mindestens eine Flip-Chip-LED befindet; und
eine Metall-Verbindungs-Schicht (26) zwischen dem Streifenelement und dem unteren Halter, um das Streifenelement und den unteren Halter elektrisch zu verbinden.

16. LED-Beleuchtungs-Bauelement vom Flip-Chip-Typ, wie in Anspruch 15 beansprucht, wobei der untere Halter (22) Schaltkreise für das Bonden der Flip-Chip-LED auf dem unteren Halter enthält.

17. LED-Beleuchtungs-Bauelement vom Flip-Chip-Typ, wie in Anspruch 15 beansprucht, wobei die Metall-Verbindungs-Schicht (26) unter einem Teil des Streifenelementes (20) und über einem Teil des unteren Halters (22) positioniert ist.

18. LED-Beleuchtungs-Bauelement vom Flip-Chip-Typ, wie in Anspruch 15 beansprucht, wobei das Material des unteren Halters (22) Silizium ist.

19. LED-Beleuchtungs-Bauelement vom Flip-Chip-Typ, wie in Anspruch 15 beansprucht, wobei das Material des Streifenelementes (20) eine Niedertemperatur-Einbrand-Keramik (LTCC) ist.

20. LED-Beleuchtungs-Bauelement vom Flip-Chip-Typ, wie in Anspruch 15 beansprucht, das weiterhin ein Wärmeleitungs-Element / einen Kühlkörper (30) auf dem Boden des unteren Halters (22) enthält.

21. LED-Beleuchtungs-Bauelement vom Flip-Chip-Typ, wie in Anspruch 20 beansprucht, wobei das Wärmeleitungs-Element / der Kühlkörper (30) am unteren Halter (22) mit einem Wärmeleitmaterial (TIM) befestigt ist.

22. LED-Beleuchtungs-Bauelement vom Flip-Chip-Typ, wie in Anspruch 21 beansprucht, wobei das Wärmeleitmaterial (TIM) aus einer Materialgruppe ausgewählt ist, die Silber-Kleber, Kupfer-Kleber oder ein Niedrigtemperatur-Lötmaterial und eine Metall-Schicht für eutektisches Bonden umfasst.

23. LED-Beleuchtungs-Bauelement vom Flip-Chip-Typ, wie in Anspruch 15 beansprucht, das weiterhin ein Licht-Sammlungs-Element (32) enthält, welches das Streifenelement bedeckt.

24. LED-Beleuchtungs-Bauelement vom Flip-Chip-Typ, wie in Anspruch 23 beansprucht, wobei das Licht-Sammlungs-Element ein Kondensor oder ein Reflektor ist.

## Revendications

1. Procédé de fabrication d'un dispositif d'éclairage à diodes électroluminescentes du type à puces retournées comprenant les étapes consistant à :
prendre une bande, ladite bande comprenant une pluralité d'éléments de bande, lesdits éléments de bande ayant une grille de connexion en métal respective, connectées électriquement respectivement les unes aux autres ;
prendre un support inférieur et une pluralité de diodes électroluminescentes à puces retournées installées dans ledit support inférieur ;
former une couche de connexion métallique entre ladite bande et ledit support inférieur pour lier ledit support inférieur à ladite bande afin de former une structure d'éclairage ; et
couper la structure d'éclairage ainsi obtenue en dispositifs d'éclairage individuels à diodes électroluminescentes du type à puces retournées basés sur chacun desdits éléments de bande.

2. Procédé de fabrication d'un dispositif d'éclairage à diodes électroluminescentes du type à puces retournées selon la revendication 1, dans lequel ledit support inférieur est un support inférieur en silicium sur lequel sont disposés des circuits pour la connexion desdites diodes électroluminescentes à puces retournées.

3. Procédé de fabrication d'un dispositif d'éclairage à diodes électroluminescentes du type à puces retournées selon la revendication 1, dans lequel ladite couche de connexion métallique est faite d'un matériau de soudure à basse température.

4. Procédé de fabrication d'un dispositif d'éclairage à diodes électroluminescentes du type à puces retournées selon la revendication 3, dans lequel ledit matériau de soudure à basse température est choisi dans un ensemble d'alliages comprenant les alliages à base d'étain, les alliages à base de bismuth et les alliages à base d'indium.

5. Procédé de fabrication d'un dispositif d'éclairage à diodes électroluminescentes du type à puces retournées selon la revendication 3, dans lequel ledit support inférieur est connecté à ladite bande par ladite couche de connexion métallique, par un chauffage de ladite couche de connexion métallique jusqu'à un état fondu.

6. Procédé de fabrication d'un dispositif d'éclairage à diodes électroluminescentes du type à puces retournées selon la revendication 1, dans lequel ladite couche de connexion métallique est faite d'une pâte adhésive conduisant l'électricité.

7. Procédé de fabrication d'un dispositif d'éclairage à diodes électroluminescentes du type à puces retournées selon la revendication 6, dans lequel ledit support inférieur est connecté à ladite bande par ladite couche de connexion métallique, par un chauffage de ladite pâte adhésive conduisant l'électricité jusqu'à un état de durcissement.

8. Procédé de fabrication d'un dispositif d'éclairage à diodes électroluminescentes du type à puces retournées selon la revendication 1, dans lequel ladite couche de connexion métallique est connectée aux grilles de connexion en métal desdits éléments de bande et audit support inférieur par fixation par eutectique.

9. Procédé de fabrication d'un dispositif d'éclairage à diodes électroluminescentes du type à puces retournées selon la revendication 1, comprenant de plus l'étape consistant à connecter un organe conduisant/dissipant la chaleur sur le support inférieur de chacun desdits dispositifs d'éclairage à diodes électroluminescentes du type à puces retournées.

10. Procédé de fabrication d'un dispositif d'éclairage à diodes électroluminescentes du type à puces retournées selon la revendication 9, dans lequel ledit organe conduisant/dissipant la chaleur est connecté audit support inférieur par l'intermédiaire d'un matériau d'interface thermique (TIM).

11. Procédé de fabrication d'un dispositif d'éclairage à diodes électroluminescentes du type à puces retournées selon la revendication 10, dans lequel ledit matériau d'interface thermique (TIM) est choisi dans un ensemble de matériaux comprenant les colles à l'argent, les colles au cuivre et les matériaux de soudure à basse température.

12. Procédé de fabrication d'un dispositif d'éclairage à diodes électroluminescentes du type à puces retournées selon la revendication 9, comprenant de plus l'étape consistant à connecter un moyen de condensation de lumière sur l'élément de bande de chacun desdits dispositifs d'éclairage à diodes électroluminescentes du type à puces retournées après la connexion d'un organe conduisant/dissipant la chaleur.

13. Procédé de fabrication d'un dispositif d'éclairage à diodes électroluminescentes du type à puces retournées selon la revendication 12, dans lequel ledit moyen de condensation de lumière comprend une lentille condensatrice et un réflecteur.

14. Procédé de fabrication d'un dispositif d'éclairage à diodes électroluminescentes du type à puces retournées selon la revendication 1, dans lequel chacun desdits dispositifs d'éclairage à diodes électroluminescentes du type à puces retournées comprend une dite grille de connexion en métal, une partie de ladite couche de connexion métallique et une partie dudit support inférieur ayant au moins une dite diode électroluminescente du type à puce retournée.

15. Dispositif d'éclairage à diodes électroluminescentes du type à puces retournées, comprenant :
un élément de bande (20) ayant une grille de connexion en métal (21) ;
un support inférieur (22) sur lequel est placée au moins une diode électroluminescente à puce retournée ; et
une couche de connexion métallique (26) entre l'élément de bande et le support inférieur pour connecter électriquement l'élément de bande et le support inférieur.

16. Dispositif d'éclairage à diodes électroluminescentes du type à puces retournées selon la revendication 15, dans lequel ledit support inférieur (22) comprend des circuits pour la connexion de ladite diode électroluminescente à puce retournée sur le support inférieur.

17. Dispositif d'éclairage à diodes électroluminescentes du type à puces retournées selon la revendication 15, dans lequel ladite couche de connexion métallique (26) est positionnée sous une partie de l'élément de bande (20) et au-dessus d'une partie du support inférieur (22).

18. Dispositif d'éclairage à diodes électroluminescentes du type à puces retournées selon la revendication 15, dans lequel le matériau du support inférieur (22) est du silicium.

19. Dispositif d'éclairage à diodes électroluminescentes du type à puces retournées selon la revendication 15, dans lequel le matériau de l'élément de bande (20) est une céramique cofrittée à basse température (LTCC).

20. Dispositif d'éclairage à diodes électroluminescentes du type à puces retournées selon la revendication 15, comprenant de plus un organe conduisant/dissipant la chaleur (30) sur une face inférieure du support inférieur (22).

21. Dispositif d'éclairage à diodes électroluminescentes du type à puces retournées selon la revendication 20, dans lequel ledit organe conduisant/dissipant la chaleur (30) est fixé audit support inférieur (22) par l'intermédiaire d'un matériau d'interface thermique (TIM).

22. Dispositif d'éclairage à diodes électroluminescentes du type à puces retournées selon la revendication 21, dans lequel ledit matériau d'interface thermique (TIM) est choisi dans un ensemble de matériaux comprenant les colles à l'argent, les colles au cuivre, les matériaux de soudure à basse température et les couches en métal de fixation par eutectique.

23. Dispositif d'éclairage à diodes électroluminescentes du type à puces retournées selon la revendication 15, comprenant de plus un élément de condensation de lumière (32) couvrant l'élément de bande.

24. Dispositif d'éclairage à diodes électroluminescentes du type à puces retournées selon la revendication 23, dans lequel ledit élément de condensation de lumière est une lentille condensatrice ou un réflecteur.
